# EUROPEAN PATENT APPLICATION

(11) **EP 4 293 518 A1**
(43) Date of publication of application: **20.12.2023**
(21) Application number: 21932178.3
(22) Date of filing: 25.03.2021
(51) Int. Cl.: G06F 11/36, G06F 30/15, G06F 30/20, G05B 17/02, G05B 23/02

(54) **TESTING SYSTEM, VEHICLE SIMULATION APPARATUS, TESTING APPARATUS AND TESTING METHOD**

(71) Applicant: Huawei Technologies Co., Ltd., Shenzhen, Guangdong 518129 (CN)
(72) Inventor: MIAO, Rui, Shenzhen, Guangdong 518129 (CN); WANG, Jiawei, Shenzhen, Guangdong 518129 (CN); CHU, Sidong, Shenzhen, Guangdong 518129 (CN)
(74) Representative: Huawei European IPR
(86) International application number: PCT/CN2021/082928
(87) International publication number: WO 2022/198550

(57) **Abstract**

This application relates to the vehicle test field, and specifically provides a test system. The test system includes: a central scheduling apparatus, a test apparatus, and a vehicle simulation apparatus. The test apparatus establishes communication with the central scheduling apparatus; the central scheduling apparatus is configured to send a test service requirement to the test apparatus; the test apparatus is configured to test the vehicle simulation apparatus based on the test service requirement; and the vehicle simulation apparatus includes a vehicle controller and a second terminal block, the vehicle controller and the test apparatus are connected to the second terminal block to establish communication, and the vehicle controller is configured to respond to the test performed by the test apparatus. This application further provides a vehicle simulation apparatus, a test apparatus, and a test method. Technical solutions of this application can be applied to large-scale tests, and have high test efficiency.

## Description

### TECHNICAL FIELD

This application relates to vehicle test technologies, and in particular, to a test system, a vehicle simulation apparatus, a test apparatus, and a test method.

### BACKGROUND

With rapid development of vehicle technologies, requirements for vehicle-mounted electronic control units (Electronic Control Units, ECUs) are increasingly high. Components of software and hardware of the ECUs are becoming more complex, and an amount of function logic between the ECUs is increasing. Therefore, a test system is required to perform verification on functions of single ECUs and function logic exchange between a plurality of ECUs before the ECUs are applied to vehicles.

At present, a test system includes a LabCar test system. The LabCar test system can be understood as a hardware in-loop system including several ECUs, and has a simulated vehicle sensor and a simulated actuating mechanism (or referred to as an actuator). The LabCar test system performs information exchange with each ECU to detect a reaction of an electronic and electrical system of a vehicle in a normal working environment. The LabCar test system may also perform fault injection manually to detect a reaction of the electronic and electrical system of the vehicle in an abnormal working environment.

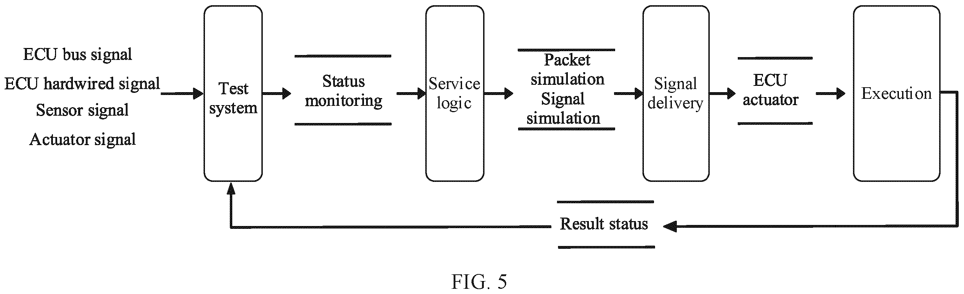

Due to a sharp increase in a test service volume, high requirements are imposed on test features that can be borne by the test system. In a LabCar test system in the conventional technology, integration of ECUs is low and depends on logic functions of the ECUs. Most test systems fulfill test task requirements for a single feature service, for example, network testing, power management, and single ECU fault injection. As shown in FIG. 5, an ECU bus signal, an ECU hardwired signal, a sensor signal, and an actuator signal are collected by a test apparatus. The test apparatus enables status monitoring, performs function logic corresponding to a to-be-tested feature service, for example, packet simulation and/or signal simulation, and delivers the signals to ECUs of a LabCar vehicle simulation apparatus. The ECUs control, by using logic of the ECUs, an actuator or a sensor to perform an action and output a result status. A system receives and processes the result status, and may further obtain a test report.

The LabCar test system can implement functions such as interface simulation and signal monitoring on tested ECUs. However, an architecture of the test system is relatively simple, a quantity of integrated ECUs is limited, and overall complexity of the test apparatus is simplified by using the logic functions of the ECUs. The LabCar test system is mainly used for vehicle control ECU detection and model simulation, and can perform in-depth tests on related features to meet verification and testing requirements of a single project for a few features. However, in an integration verification testing phase, the low-integration LabCar test system is relatively isolated and helpless, and can cover only a few test services. This cannot meet requirements of large-scale testing and verification in the integration verification phase.

For example, in the LabCar test system, when an ECU interface is changed or switching is performed between different projects, software and hardware of the test apparatus are greatly changed, system flexibility is quite low, adaptation cannot be performed rapidly, and a repeated workload is large. As a result, a development cycle is long and test resources are wasted. In addition, exchanging data based on the logic functions of the ECUs easily causes a function failure of the vehicle simulation apparatus when a fault occurs in a single ECU.

In addition, when a plurality of LabCar test systems run in parallel, the vehicle test systems are isolated from each other, cannot exchange data and logic functions with each other, and lack unified scheduling in general. As a result, coverage of end-to-end service tests is severely limited, execution efficiency of testing and verification is low, and human and material resources are wasted.

Therefore, the applicant considers that the existing LabCar test system cannot meet a requirement of a large-scale test service volume.

### SUMMARY

In view of the foregoing problems in the conventional technology, this application provides a test system, a vehicle simulation apparatus, a test apparatus, and a test method, to improve integration and adaptability of a test environment, thereby meeting a requirement of a large-scale test service volume.

The foregoing and other objectives are achieved by using features in the independent claims. Further implementations are embodied in the dependent claims, this specification, and the accompanying drawings.

According to a first aspect of this application, a test system is provided, including a central scheduling apparatus, a test apparatus, and a vehicle simulation apparatus, where the test apparatus establishes communication with the central scheduling apparatus;
the central scheduling apparatus is configured to send a test service requirement to the test apparatus;
the test apparatus is configured to test the vehicle simulation apparatus based on the test service requirement; and
the vehicle simulation apparatus includes a vehicle controller and a second terminal block, the vehicle controller and the test apparatus are connected to the second terminal block to establish communication, and the vehicle controller is configured to respond to the test performed by the test apparatus.

As described above, in an integration testing phase, the central scheduling apparatus may be used as a human-machine interaction interface to deliver a test command, so that a user conveniently manages a plurality of test apparatuses together, and then a plurality of vehicle simulation apparatuses can receive a test service requirement in parallel. This improves integration of a test environment, improves execution efficiency of testing, and reduces human and material resources used.

In addition, the vehicle controller and the test apparatus are connected to the second terminal block to establish communication, to implement decoupling between the vehicle controller of the vehicle simulation apparatus and the test apparatus. When an interface definition of the vehicle controller changes, or the vehicle simulation apparatus is entirely used for different projects, the vehicle simulation apparatus can still entirely meet channel matching and line connection requirements of the test apparatus at minimum costs. To be specific, the second terminal block is disposed to separate the vehicle simulation apparatus from the test apparatus, and a change of the vehicle simulation apparatus in a logic function does not cause a change of the test apparatus. Even for different test projects, the test apparatus only needs to perform simple software modification, to perform adaptation between the different projects, thereby meeting requirements of rapid deployment and high integration and high replicability of the test apparatus. Terminal blocks in vehicle simulation apparatuses achieve universality, that is, platformization, of the vehicle simulation apparatuses. Therefore, the foregoing configuration mode can significantly improve execution efficiency especially in case of large-scale integration testing.

In a possible implementation of the first aspect, the vehicle simulation apparatus further includes an electrical load and a first terminal block, and the vehicle controller and the electrical load are connected to the first terminal block to establish communication.

As described above, decoupling between the vehicle controller and the electrical load is implemented by using the first terminal block, and the tested vehicle controller and the needed electrical load may be correspondingly connected based on a test requirement. It can be learned that the universality of the vehicle simulation apparatuses, that is, platformization, is further implemented.

In a possible implementation of the first aspect, the first terminal block is further connected to the second terminal block.

As described above, the first terminal block is connected to the second terminal block, so that each electrical load in the vehicle simulation apparatus may be further connected to the test apparatus through the second first terminal block and the second terminal block and is monitored by the test apparatus, a signal between the vehicle controller and the electrical load is monitored by the test apparatus, and a condition is created for the test apparatus to simulate an interface circuit signal of the electrical load.

In a possible implementation of the first aspect, an interface that is of the second terminal block and that is configured to establish communication includes a digital channel interface, an analog channel interface, and/or a bus channel interface.

As described above, the channel interfaces of the test apparatus perform an all-signal-type configuration for the vehicle controller, and provide a fixed quantity of digital, analog, and bus channels, so that the channel interfaces of the test apparatus are universal and are unrelated to the vehicle controller. A quantity of signal collection and output channels can be flexibly adjusted based on a total quantity of interface types of the vehicle controller, to avoid a problem of a huge repeated workload for re-adaptation of software and hardware of the test apparatus due to different interface types of the vehicle controller or a change in a quantity of interfaces of the vehicle controller. This effectively shortens a development cycle and improves utilization of test resources.

In a possible implementation of the first aspect, the vehicle simulation apparatus includes at least two vehicle controllers, and the test apparatus is further configured to implement communication between the at least two vehicle controllers.

As described above, interaction between the vehicle controllers may be decoupled, and interaction functions of the vehicle controllers may be implemented by using the test apparatus, to avoid a risk that exchanging information based on logic functions of the vehicle controllers easily causes a function failure of the vehicle simulation apparatus when a fault occurs in a single controller. In addition, in this manner, the test apparatus may also monitor information exchanged between the vehicle controllers, to obtain the information in an interaction process between the vehicle controllers.

In a possible implementation of the first aspect, there are at least two test apparatuses, there are at least two vehicle simulation apparatuses, and the at least two vehicle simulation apparatuses establish communication with the at least two test apparatuses in a one-to-one correspondence manner; and the central scheduling apparatus is further configured to implement communication between the at least two test apparatuses.

As described above, data forwarding between the test apparatuses is implemented by using the central scheduling apparatus. The upper-layer central scheduling apparatus serves as a common management and forwarding node of the test apparatuses, and provides a path for data and logic exchange between the vehicle simulation apparatuses coupled to the test apparatuses. When a fault occurs in an individual controller in a vehicle simulation apparatus, data and logic functions of a controller of a same type in another vehicle simulation apparatus can be used to complete a test task. In addition, the vehicle simulation apparatuses may further perform cooperation and coordination. In this way, function complementation capabilities for integrated testing are greatly enhanced, and different integration environment configurations are flexibly performed for different feature test requirements, to avoid a waste of integration environment or instrument/device resources.

In a possible implementation of the first aspect, the central scheduling apparatus is further configured to implement data management on each of the test apparatuses.

As described above, the central scheduling apparatus manages test data of the vehicle simulation apparatuses coupled to the plurality of test apparatuses together, to meet requirements of forwarding the test data between the vehicle simulation apparatuses and interaction between the vehicle simulation apparatuses.

In a possible implementation of the first aspect, the test performed by the test apparatus includes at least one of the following: performing monitoring or data collection on the vehicle controller; performing monitoring or data collection on the electrical load; providing a simulated interface electrical signal of the electrical load; performing fault injection on the vehicle controller; or processing collected data.

As described above, universal platformization setting is performed on test functions of the test apparatuses, to meet requirements of a plurality of types of test services, so that software code for implementing these test functions can be deployed in batches, and there is no difference between platforms. This facilitates portability and reuse, and improves software development efficiency of the test apparatuses.

According to a second aspect of this application, a vehicle simulation apparatus is provided, including a vehicle controller and a second terminal block. The vehicle controller and a test apparatus are connected to the second terminal block to establish communication.

As described above, the second terminal block is disposed on the vehicle simulation apparatus, so that the vehicle controller and the test apparatus can be connected to the second terminal block to establish communication, thereby implementing decoupling between the vehicle controller of the vehicle simulation apparatus and the test apparatus. When an interface definition of the vehicle controller changes, or the vehicle simulation apparatus is entirely used for different projects, the vehicle simulation apparatus can still entirely meet channel matching and line connection requirements of the test apparatus at minimum costs. To be specific, the second terminal block is disposed to separate the vehicle simulation apparatus from the test apparatus, and a change of the vehicle simulation apparatus in a logic function does not cause a change of the test apparatus. Even for different test projects, the test apparatus only needs to perform simple software modification, to perform adaptation between the different projects, thereby meeting requirements of rapid deployment and high integration and high replicability of the test apparatus. Terminal blocks in vehicle simulation apparatuses achieve universality, that is, platformization, of the vehicle simulation apparatuses.

In a possible implementation of the second aspect, the vehicle simulation apparatus further includes an electrical load and a first terminal block, and the vehicle controller and the electrical load are connected to the first terminal block to establish communication.

As described above, decoupling between the vehicle controller and the electrical load is implemented by using the first terminal block, and the tested vehicle controller and the needed electrical load may be correspondingly connected based on a test requirement. It can be learned that the universality of the vehicle simulation apparatuses, that is, platformization, is further implemented.

In a possible implementation of the second aspect, the first terminal block is further connected to the second terminal block.

As described above, the first terminal block is connected to the second terminal block, so that each electrical load in the vehicle simulation apparatus may be further connected to the test apparatus through the first terminal block and the second terminal block and is monitored by the test apparatus, a signal between the vehicle controller and the electrical load is monitored by the test apparatus, and a condition is created for the test apparatus to simulate an interface circuit signal of the electrical load.

According to a third aspect of this application, a test apparatus is provided, including a communication engine module, a local logic engine module, a hardware management engine module, and a data processing engine module, where
the communication engine module is configured to receive a test service requirement of a central scheduling apparatus;
the local logic engine module is configured to implement a test case that fulfills the test service requirement, where the test case is used to describe service logic for testing a vehicle simulation apparatus;
the hardware management engine module is configured to manage running of a test device in the test apparatus in a process of implementing the test case, where the test device is configured to provide test signals for the vehicle simulation apparatus or collect data of the vehicle simulation apparatus; and
the data processing engine module is configured to process the data collected by the test device.

As described above, test functions that serve the test service requirement are classified into a plurality of engine modules based on types. The communication engine module is configured to externally communicate with the current test apparatus, may receive a remote scheduling command that is of the upper-layer central scheduling apparatus and that is used for scheduling a plurality of test apparatuses, and further has a capability of implementing communication between a plurality of vehicle simulation apparatuses through communication with the central scheduling apparatus. The service logic can be understood as an execution process of control logic between vehicle controllers, or between a vehicle controller and a sensor or an actuator. When a test requirement involves verification on whether the vehicle controller effectively controls electrical loads such as the actuator, the sensor, and other peripherals, the local logic engine module is responsible for performing an automated test and fault injection. In addition, test hardware of the hardware management engine module may be used to simulate signals of the peripherals by using the test case, to implement a needed test task. The hardware management engine module is responsible for implementing and checking functions of the vehicle controller in a normal or abnormal condition, and scheduling the test device, for example, a board. The data processing engine module is responsible for data storage and data computing in the test apparatus, to further meet test requirements of various feature service tests, such as requirements for data precision, data analysis, and data visualization. By using the foregoing engine module, the test apparatus can smoothly implement data exchange and logic exchange between vehicle controllers of the vehicle simulation apparatus, and can provide a reliable basis for an efficient implementation of a large-scale test service volume in a complex scenario in which a plurality of test projects are integrated.

In a possible implementation of the third aspect, the test apparatus further includes a main control module, configured to control running of the communication engine module, the local logic engine module, the hardware management engine module, and the data processing engine module.

As described above, the main control module controls the running of the functional modules, so that functions of the engine modules can be independently performed and logically independent of each other. In this way, it is convenient for the functional modules to perform respective functions in a concurrent thread manner. For example, the engine modules can be dynamically invoked in parallel based on a test requirement, or CPU resources can be allocated to the engine modules, so that test service efficiency is improved. In addition, when a fault occurs in a function, a corresponding engine module may be disabled alone under the control of the main control module, without affecting independent normal running of functions of other engine modules.

In a possible implementation of the third aspect, the test apparatus further includes a local test service functional submodule controlled by the communication engine module, where the local test service functional submodule is configured to collect the data of the vehicle simulation apparatus through signal transmission by using a network transmission protocol.

As described above, the local test service functional submodule is packaged in the communication engine module. This facilitates proper allocation of communication resources and improvement of transmission efficiency.

In a possible implementation of the third aspect, the test apparatus further includes a hardware functional submodule for testing a digital parameter, a hardware functional submodule for testing an analog parameter, and/or a hardware functional submodule for testing a bus signal, where these hardware functional submodules are controlled by the hardware management engine module.

As described above, the test devices used for testing the vehicle controllers are all packaged on threads managed by the hardware management engine module, and the test functions are performed in forms of functional submodules of various signal types, so that the functions of the test devices are performed independently as much as possible. In a scenario with many data types and a large data volume, a failure in any test device does not affect continuous efficient running of other test devices.

In a possible implementation of the third aspect, the test apparatus further includes a signal channel operation submodule controlled by the hardware functional submodule, where the signal channel operation submodule is configured to control the test device to provide test signals or collect data on a digital channel, an analog channel, and/or a bus channel based on a signal type.

As described above, signal channel operation submodules scheduled by the hardware functional submodules respectively implement actual operations on specific board drivers that are based on the digital parameter, the analog parameter, and the bus signal. This can disperse a thread bearing capacity and determine a data flow direction.

In a possible implementation of the third aspect, each engine module, each functional submodule, and each operation submodule include an upper queue, a local queue, and a lower queue; the upper queue is configured to implement information exchange with an upper-layer module; the local queue is configured to implement information exchange between an upper queue and a lower queue in a current module; and the lower queue is configured to implement information exchange with a lower-layer module;
an upper-layer module of the engine module is the main control module, and a lower-layer module of the engine module is a submodule controlled by the engine module;
an upper-layer module of the functional submodule is an engine module that controls the functional submodule, and a lower-layer module of the functional submodule is an operation submodule controlled by the functional submodule; and
an upper-layer module of the operation submodule is a functional submodule that controls the operation submodule, and a lower-layer module of the operation submodule is a submodule that is controlled by the operation submodule and that is used for extension.

As described above, based on the foregoing multi-layer functional modules that use the concurrent thread manner, an internal structure of the upper queue, the local queue, and the lower queue can implement data transmission and processing between a plurality of functional modules, and data flows for transmitting scheduling instructions from an upper layer to a lower layer and feeding back data from a lower layer to an upper layer are separated, to implement data exchange between a parent thread and a subthread.

In addition, threads on which the engine modules, functional submodules, and operation submodules are located are all designed as being in three-layer queue forms in the threads, and the three-layer queue form includes an upper queue, a local queue, and a lower queue. Such queue forms can support data transmission and data processing between the threads but do not directly exchange data, to avoid logic function disorder caused by random data forwarding.

Moreover, by using a three-layer queue structure, a functional module can continue to be extended downwards into more submodules. When larger-scale data is exchanged, a working mode in which an operation submodule further schedules a lower-layer submodule of the operation submodule still complies with a parallel and highly concurrent thread principle, and supports scalability and reliability in terms of software.

In a possible implementation of the third aspect, the engine module further includes a display refreshing engine module, configured to refresh to-be-displayed data.

As described above, the display refreshing engine module provides data refresh and possible display services of the test apparatus. When the test apparatus undertakes an independent test task, or receives, in an integration testing scenario, upper-layer scheduling instructions to undertake a local test task and a cross task, the display refreshing engine module may be used to implement interaction with a user and implement independent parallel running with other engine modules, and may work in a background.

In a possible implementation of the third aspect, the test apparatus further includes a remote data transmission functional submodule scheduled by the communication engine module, configured to implement information exchange with the central scheduling apparatus by using the network transmission protocol.

As described above, as one of first-layer functional submodules in a downstream of the communication engine module, the remote data transmission functional submodule undertakes specific external communication, provides a path for receiving external scheduling instructions in the integration testing scenario, and is an interface for data exchange between the current test apparatus and an external device. The remote data transmission functional submodule may use the network transmission protocol, for example, a TCP/IP, so that each test apparatus communicates with the central scheduling apparatus, and further communicates with other test apparatuses through the central scheduling apparatus. This is especially applicable to a communication requirement of integration testing in a cross-region test environment.

In a possible implementation of the third aspect, the test apparatus further includes a data logic functional submodule controlled by the data processing engine module, configured to perform logic processing on the collected data of the vehicle simulation apparatus.

As described above, database logic occupies a large quantity of thread resources, and therefore it is necessary to allocate separate threads to process test data. This can reduce logic function disorder caused by random data forwarding.

In a possible implementation of the third aspect, the test apparatus further includes a database management operation submodule controlled by the data logic functional submodule, configured to perform a data operation in a database.

As described above, the database management operation submodule controlled by the data logic functional submodule performs data operations in the database, such as data storage, playback, and analysis, to disperse a thread bearing capacity and determine a data flow direction.

In a possible implementation of the third aspect, the test apparatus further includes an interface data interaction functional submodule controlled by the data processing engine module, configured to implement an interaction interface function of the test apparatus.

As described above, when a test process needs to be displayed in a foreground, the interface data interaction functional submodule may interact with an interface that is of the test apparatus and that is used for displaying test statuses or test results. The interface of the test apparatus is, for example, a user interface (UI) or a front panel (Front Panel).

In a possible implementation of the third aspect, the test apparatus further includes a display refreshing functional submodule and/or a user interface message functional submodule that are/is controlled by the display refreshing engine module, where the display refreshing functional submodule is configured to present the test signals and the test statuses of the vehicle simulation apparatus, and the user interface message functional submodule is configured to present messages of determining results of the test signals and the test statuses.

As described above, the display refreshing functional submodule and the user interface message functional submodule that are controlled by the display refreshing engine module run on different concurrent threads based on content presented to the user, and may display the test signals, the test statuses, and the determining results or conclusions independently. When the central scheduling apparatus invokes a plurality of test apparatuses, a display function of the display refreshing engine module is presented on an interface of the central scheduling apparatus.

In a possible implementation of the third aspect, the test apparatus further includes an automated test functional submodule controlled by the local logic engine module, configured to: store an automated test case, and implement, based on the automated test case, the service logic of the test functions corresponding to the test service requirement.

As described above, the automated test functional submodule in the test apparatus may test a feature of the vehicle controller, especially a control logic feature, to automatically implement control scenarios such as simulation of logic power-on/off and an interface circuit by using specific steps of the test case, and even implement fault injection, thereby completing a test on whether a service function of the vehicle controller is normal.

According to a fourth aspect of this application, a test method applied to the test system according to any one of the first aspect or the possible implementations of the first aspect is provided. A vehicle controller of a vehicle simulation apparatus and a test apparatus are connected to a second terminal block of the vehicle simulation apparatus to establish communication between the vehicle controller and the test apparatus, and the test method includes the following steps:
a central scheduling apparatus sends a test service requirement to the test apparatus;
the test apparatus tests the vehicle simulation apparatus based on the test service requirement; and
the vehicle controller of the vehicle simulation apparatus responds to the test performed by the test apparatus.

In a possible implementation of the fourth aspect, the vehicle simulation apparatus further includes an electrical load and a first terminal block, and the test method further includes: The vehicle controller and the electrical load are connected to the first terminal block to establish communication.

In a possible implementation of the fourth aspect, the vehicle simulation apparatus includes at least two vehicle controllers, and the test method further includes: performing communication between the at least two vehicle controllers by using the test apparatus.

In a possible implementation of the fourth aspect, there are at least two test apparatuses, there are at least two vehicle simulation apparatuses, and the at least two vehicle simulation apparatuses establish communication with the at least two test apparatuses in a one-to-one correspondence manner; and the test method further includes: the central scheduling apparatus performs communication between the at least two test apparatuses.

In a possible implementation of the fourth aspect, the test performed by the test apparatus includes at least one of the following:
performing monitoring or data collection on the vehicle controller;
performing monitoring or data collection on the electrical load;
providing a simulated interface electrical signal of the electrical load;
performing fault injection on the vehicle controller; or
processing collected data.

According to a fifth aspect of this application, a test method applied to the test apparatus any one of the third aspect or the possible implementations of the third aspect is provided, including the following steps:
a communication engine module receives a test service requirement of a central scheduling apparatus;
a local logic engine module implements a test case that fulfills the test service requirement, where the test case is used to describe service logic for testing a vehicle simulation apparatus;
a hardware management engine module manages running of a test device in the test apparatus in a process of implementing the test case, where the test device is configured to provide test signals for the vehicle simulation apparatus or collect data of the vehicle simulation apparatus; and
a data processing engine module processes the data collected by the test device.

In a possible implementation of the fifth aspect, the method further includes: A main control module controls running of the communication engine module, the hardware management engine module, the data processing engine module, and the local logic engine module.

In a possible implementation of the fifth aspect, each engine module, each functional submodule, and each operation submodule include an upper queue, a local queue, and a lower queue;
the upper queue performs information exchange with an upper-layer module;
the local queue performs information exchange between an upper queue and a lower queue in a current module;
the lower queue performs information exchange with a lower-layer module;
an upper-layer module of the engine module is the main control module, and a lower-layer module of the engine module is a submodule controlled by the engine module;
an upper-layer module of the functional submodule is an engine module that controls the functional submodule, and a lower-layer module of the functional submodule is an operation submodule controlled by the functional submodule; and
an upper-layer module of the operation submodule is a functional submodule that controls the operation submodule, and a lower-layer module of the operation submodule is a submodule that is controlled by the operation submodule and that is used for extension.

In a possible implementation of the fifth aspect, scheduling in the test is performed based on a scheduling priority of each module, where the scheduling priority is set based on a priority of the test service requirement.

As described above, a scheduling priority policy of the modules is determined based on test service requirements and priorities of function logic corresponding to the service requirements, so that a user may not completely conform to an original default scheduling policy of a computer operating system, but manually adjust thread scheduling priorities of the functional modules, to meet a delay requirement of a functional module that needs to run at a high speed, and improve execution efficiency of an important function.

In a possible implementation of the fifth aspect, the test method further includes: controlling, by using a timeout control algorithm, sorting of modules with a same scheduling priority, and increasing a scheduling priority of a module whose timeout times reach a preset quantity of times by one level.

As described above, during processing of large-scale data, there is still a case in which scheduling priorities of a plurality of modules that work in parallel cannot be accurately determined. Consequently, proper and real-time computing or scheduling resources cannot be allocated to the modules in time, and processing sequences of modules that are set to have a same scheduling priority are always different actually. In this application, the timeout control algorithm is used to dynamically adjust module sorting in this case, to avoid incorrect disabling or suspension of a thread on which a module is located in an individual case.

According to a sixth aspect of this application, a computing device is provided, including: a bus; a communication interface, which is connected to the bus; at least one processor, which is connected to the bus; and; and at least one memory, which is connected to the bus and stores program instructions, where when the program instructions are executed by the at least one processor, the at least one processor is enabled to perform any one of the foregoing methods.

According to a seventh aspect of this application, a computer-readable storage medium is provided. The computer-readable storage medium stores program instructions, and when the program instructions are executed by a computer, the computer is enabled to perform any one of the foregoing methods.

In summary, according to technical solutions of this application, high platformization can be implemented for the vehicle simulation apparatuses and the test apparatuses. Even if the vehicle simulation apparatuses and the test apparatuses are used for different projects, the test apparatuses that use a redundant-channel configuration policy can be adapted to different interfaces of the vehicle controllers of the vehicle simulation apparatuses with smallest changes, and logic functions of the vehicle controllers are decoupled from those of the test apparatuses. This provides a great gain for subsequent batch deployment. In addition, in the technical solutions of this application, unified scheduling is further implemented on the vehicle simulation apparatuses, data exchange and function complementation are implemented between different test apparatuses, and the vehicle controllers and test hardware are managed together. This greatly improving adaptability, integration, deployment efficiency, and a service bearing capability of the test environment. Especially in an integration verification phase, in a scenario in which test projects need to be deployed on a large scale, the technical solutions of this application can be well adapted to test requirements in an integration environment.

The foregoing and other objectives are achieved by using the features in the independent claims. Further implementations are embodied in the dependent claims, this specification, and the accompanying drawings.

These and other aspects of the present invention are more concise and comprehensible in descriptions of the following (plurality of) embodiments.

### BRIEF DESCRIPTION OF DRAWINGS

The following further describes features of the present invention and relationships between the features with reference to the accompanying drawings. The accompanying drawings are all examples, and some features are not shown in actual proportions. In addition, in some accompanying drawings, common features that are not mandatory for this application and that are in the field of this application may be omitted, or features that are not mandatory for this application are additionally shown. A combination of the features shown in the accompanying drawings is not intended to limit this application. Moreover, in this specification, content indicated by same reference numerals is also the same. The specific accompanying drawings are described as follows:
FIG. 1 is a schematic diagram of an architecture of a test system according to an embodiment;
FIG. 2 is a principle diagram of a vehicle simulation apparatus and a test apparatus according to an embodiment;
FIG. 3 is a schematic diagram of a logical architecture of a test apparatus according to an embodiment;
FIG. 4 is a schematic diagram of a structure of a computing device according to an embodiment; and
FIG. 5 is a schematic diagram of a principle of a test process of a LabCar test system in the conventional technology.

### DESCRIPTION OF EMBODIMENTS

In this specification and claims, terms "first, second, third, and the like" or similar terms such as a module A, a module B, and a module C are merely used to distinguish between similar objects, and do not represent a specific order of the objects. It can be understood that specific orders or sequences are interchangeable if permitted, so that embodiments of this application described herein can be implemented in a sequence other than a sequence illustrated or described herein.

In the following descriptions, numbers indicating steps such as S 110 and S 120 do not necessarily indicate that the steps are performed in this sequence, and the steps may be performed in another sequence or may be performed simultaneously if permitted.

A term "include" used in this specification and claims should not be construed as being limited to content listed below, and does not exclude other elements or steps. Therefore, the term should be construed as specifying existence of a mentioned feature, whole, step, or component, but does not exclude existence or addition of one or more other features, wholes, steps, or components, and their groups. An expression "a device including apparatuses A and B" should not be limited to a device including only the components A and B.

"One embodiment" or "an embodiment" mentioned in this specification indicates that a particular feature, structure, or characteristic described in combination with the embodiment is included in at least one embodiment of the present invention. Therefore, phrases "in one embodiment" or "in an embodiment" that appear in various parts of this specification do not necessarily indicate a same embodiment, but possibly indicate a same embodiment. In addition, in one or more embodiments, the particular features, structures, or characteristics can be combined in any proper manner, as it is clear from this disclosure to a person of ordinary skill in the art.

Unless otherwise defined, all technical and scientific terms used in this specification have same meanings as those usually understood by a person skilled in the art of this application. In case of any inconsistency, the meanings described in this specification or the meanings obtained based on content recorded in this specification are used. Moreover, the terms used in this specification are merely for the purpose of describing embodiments of this application, but are not intended to limit this application.

When a test system verifies function logic of a vehicle or ECUs of the vehicle, integration and a deployment quantity of the test system directly affect coverage of feature service tests. A platformization/universality degree of vehicle simulation apparatuses directly affects efficiency of deploying the vehicle simulation apparatuses and an optimized configuration of instrument/device resources. Therefore, the applicant proposes a test system in this application. The following provides detailed descriptions.

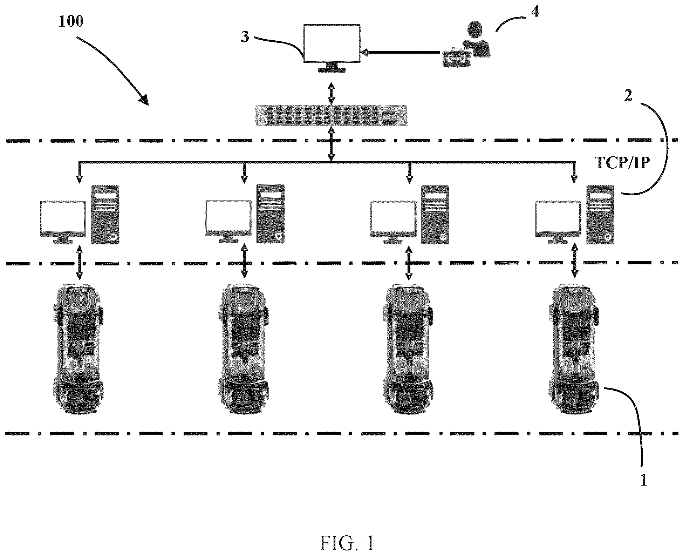

As shown in FIG. 1, an embodiment of this application provides a test system 100. The test system 100 uses a three-layer architecture and includes vehicle simulation apparatuses 1, test apparatuses 2, and a central scheduling apparatus 3.

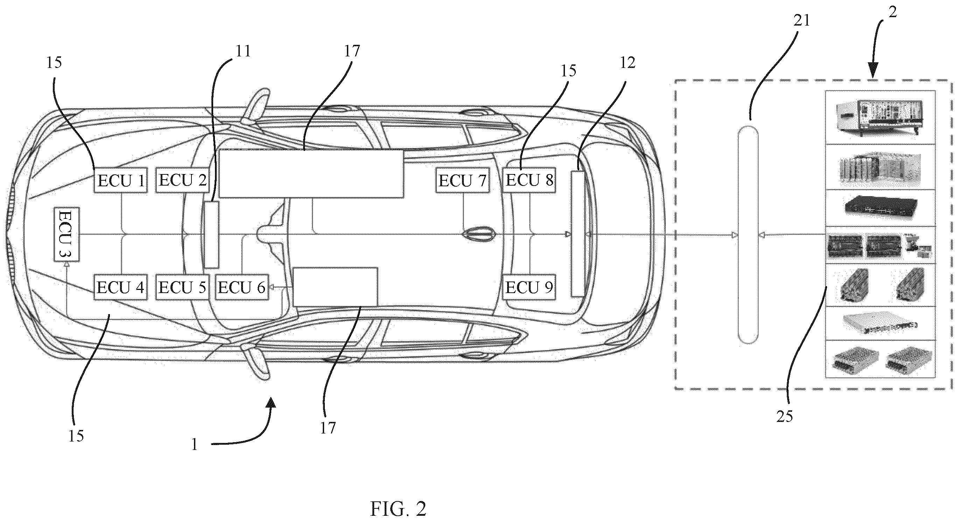

As shown in FIG. 1 and FIG. 2, a vehicle simulation apparatus 1 is provided with at least one vehicle controller 15, for example, but not limited to, an ECU, a domain control unit (Domain Control Unit, DCU), a multi-domain controller (Multi Domain Controller, MDC), a vehicle control unit (Vehicle Control Unit, VCU), and a tested-vehicle controller related to vehicle testing, and is further provided with an electrical load 17 coupled to the vehicle controller 15, for example, a simulated and/or real load, a peripheral including a sensor, an actuating mechanism, or an actuator, and an electrical channel such as a bus. In an integration testing phase, a plurality of vehicle simulation apparatuses 1 may be disposed, and each vehicle simulation apparatus 1 is provided with at least one vehicle controller 15 and a related electrical load 17 corresponding to a vehicle model for a test project. It should be noted that in this embodiment, an example in which only an ECU is used as the vehicle controller 15 is used for description.

As shown in FIG. 1 to FIG. 3, a test apparatus 2 is configured to test a coupled vehicle simulation apparatus 1 especially a vehicle controller 15 or an electrical load 17 in the vehicle simulation apparatus 1 based on a test service requirement, and includes a test device 25 and test software 26. The test device 25 includes various instruments/devices used for testing. The test device 25 is configured to monitor statuses of the vehicle controller 15 and the electrical load 17 through control of the test software 26, and may further perform packet simulation and signal simulation based on service logic corresponding to the test requirement and by using the test software 26. The test device 25 may be set in a form of a board. In this embodiment, PCI extension (PCI extensions for Instrumentation Express, PXIe) series boards are used, including but not limited to a high-level digital parameter I/O board, a multi-functional signal collection board, and a dynamic analog-parameter output board, so that the test apparatus 2 can control or monitor the vehicle controller 15 and the electrical load 17 in the vehicle simulation apparatus 1 directly connected to the test apparatus 2, to obtain a related status and collect data. The test device 25 may further perform packet simulation based on the service logic corresponding to the test requirement and by using the test software 26, simulate a peripheral electrical interface to provide a needed interface electrical signal, and is further responsible for power management of a vehicle ECU, for example, power-on/off of the ECU, or power-on/off logic related to the ECU such as power-on/off of the electrical load 17 on a premise of an ECU startup. Therefore, the test apparatus 2 in this application may implement logic exchange, and is responsible for processing a hard wire (the hard wire is a line that transmits a high/low level) and bus data.

As shown in FIG. 1, the central scheduling apparatus 3 may communicate with at least one test apparatus, is configured to provide a user interaction interface and schedule running of the test apparatuses 2 based on user instructions, and is further configured to implement information exchange between the test apparatuses 2. In this way, unified scheduling is performed, by using the test apparatuses 2, on corresponding vehicle simulation apparatuses 1 coupled to the test apparatuses 2. In the integration testing phase, the central scheduling apparatus 3 provides an interface that can be used for interacting with a user 4, and schedules the test apparatuses 2 in parallel based on the user instructions. User interaction work of each test apparatus 2 is handed over to the central scheduling apparatus 3 for implementation. In this way, that a person needs to be allocated to each test apparatus 2 to complete an integration test task is avoided, and only one person is allocated for the central scheduling apparatus 3 to complete the entire integration test task. In addition, the central scheduling apparatus 3 is further configured to implement data management on each test apparatus 2, including local data management and cloud data management, and management functions such as adding, deleting, modifying, and querying a test case of each test apparatus 2. When at least two vehicle simulation apparatuses 1 interact with each other, each test apparatus 2 communicates with the central scheduling apparatus 3, to meet requirements of forwarding test data of ECUs between the vehicle simulation apparatuses 1 and interaction between the vehicle simulation apparatuses 1.

The three-layer architecture of the test system 100 enables the plurality of vehicle simulation apparatuses 1 and the corresponding test apparatuses 2 to be presented as a distributed architecture, and enables the central scheduling apparatus 3 to perform unified scheduling on the vehicle simulation apparatuses 1 and the test apparatuses 2.

Because each vehicle simulation apparatus 1 and a coupled test apparatus 2 are generally located in a same region, the test apparatus 2 may also be referred to as a local-end test apparatus. In this embodiment, each vehicle simulation apparatus 1 is corresponding to one test apparatus 2.

It can be understood that, for a single test project, a single test apparatus 2 and a vehicle simulation apparatus 1 coupled to the test apparatus 2 can still independently test a vehicle ECU or several ECUs corresponding to a vehicle model, and the single test apparatus 2 can implement interaction with the user.

In this embodiment, electrical loads such as a vehicle ECU, sensors, and actuators corresponding to each vehicle model for each project may be disposed on a plurality of vehicle simulation apparatuses 1 corresponding to the vehicle model, and are independently tested by test apparatuses 2 coupled to the vehicle simulation apparatuses 1. When integration testing needs to be performed on different projects, especially when test requirements of the different projects are imposed in different regions, the user 4 may directly deliver instructions for a test service requirement of one or more of the vehicle simulation apparatuses 1 by using the central scheduling apparatus 3. The central scheduling apparatus 3 monitors or schedules a plurality of test apparatuses 2 in different regions separately and/or in parallel, so that the test apparatuses 2 respectively test the coupled vehicle simulation apparatuses 1; and the central scheduling apparatus 3 manages data sent by the test apparatuses 2.

FIG. 2 is a principle diagram of a vehicle simulation apparatus and a test apparatus. The vehicle simulation apparatus simulates an actual vehicle environment, is distributed with a plurality of vehicle controllers 15, for example, an ECU 1 to an ECU 9, and is provided with various electrical loads 17, including but not limited to various real or simulated actuators such as a light, a MIC, a speaker, a steering wheel, a gear shift, a throttle, a brake, a head-up display (Head-Up Display, HUD), a simulated door lock, and a seat, various sensors such as a radar and a camera, and other peripherals such as a central control system and a meter.

In this embodiment, on the vehicle simulation apparatus 1, a first terminal is disposed at a local end of an ECU (a side close to the ECU). For example, FIG. 2 schematically shows a first terminal block in a form of a front-end terminal block 11, which is configured to implement a configurable connection between the vehicle controllers 15 and the electrical loads 17. As shown in FIG. 2, the ECU 1 to the ECU 9 may be connected to the electrical loads 17 such as actuators by using the front-end terminal block 11. In this way, if an interface definition of the ECUs changes, or the vehicle simulation apparatus 1 is entirely used for different ECUs for different projects, the vehicle simulation apparatus 1 can still entirely meet channel matching and line connection requirements of the test apparatus 2 at minimum costs.

The vehicle simulation apparatus 1 is further provided with a second terminal. For example, FIG. 2 schematically shows a second terminal block in a form of a middle terminal block 12. The second terminal block may be placed on the vehicle simulation apparatus 1 as shown in FIG. 2, or may be placed independently of the vehicle simulation apparatus 1 and the coupled test apparatus 2, and is configured to implement a configurable connection between the vehicle simulation apparatus 1 and the test apparatus 2. Specifically, the second terminal block may implement a configurable connection between the first terminal block and the test apparatus 2 and a configurable connection between the electrical loads 17 and the test apparatus 2, so that the ECUs of the vehicle simulation apparatus 1 separately pass through the first terminal block and the second terminal block, electrical interfaces of the ECUs are all led into the test apparatus 2 to be separately monitored by the test apparatus, and the electrical loads 17 may also be directly monitored by the test apparatus 2 by using the second terminal block. In this way, any state change or function implementation is not affected when the electrical loads 17 are controlled by the ECUs to perform an action or when the ECUs are not affected. In addition, if there is no real actuator in the vehicle simulation apparatus 1, signals such as a Boolean value signal, a voltage signal, and a resistance signal of an actuator that are simulated by the test apparatus 2 may be directly led into the coupled vehicle controller by using the second terminal block and then the first terminal block, to implement interaction between the test apparatus 2 and the coupled vehicle controller. In this way, a test process of service feature logic of the vehicle controller is completed. Moreover, the test apparatus 2 provides an electrical channel adaptation layer 21, configured to: during implementation of the configurable connection between the first terminal block and the test apparatus, implement adaptation between a channel of the test device 25 of the test apparatus 2 and channels of the ECUs of the corresponding vehicle simulation apparatus 1, and between the channel of the test device 25 and channels of the electrical loads 17. The vehicle simulation apparatus 1 and the test apparatus 2 are physically separated by using the second terminal block on the side of the vehicle simulation apparatus 1 and the electrical channel adaptation layer 21 on the side of the test apparatus 2. Furthermore, a change of the vehicle simulation apparatus 1 in a logic function does not cause a change of the test apparatus 2. This meets requirements of rapid deployment and high integration and high replicability of the test apparatus.

Further, in this embodiment, the electrical channel adaptation layer 21 of the test apparatus 2 performs a channel redundancy configuration with respect to signal collection and output channels of the test device 25. The electrical channel adaptation layer 21 of the test apparatus 2 includes a preset fixed quantity of digital channel interfaces, analog channel interfaces, bus channel interfaces, and the like, such as a digital in and out (Digital In and Out, DIO) channel interface, an analog in and out (Analog In and Out, AIO) channel interface, a pulse width modulation (Pulse Width Modulation, PWM) channel interface, a 5V, 12V, or 24V electrical signal channel interface, and a controller area network (Controller Area Network, CAN)/local interconnect network (Local Interconnect Network, LIN) channel interface. An all-signal-type configuration may be performed relative to a total quantity of signal types of the ECUs, so that platformization can be implemented for the test apparatuses under a policy of the all-signal-type configuration. Even for different test projects, the test apparatus 2 can conveniently perform adaptation on signal types between the different projects, to implement relative independence of the test apparatus 2 and the ECUs of the vehicle simulation apparatus 1. In addition, a quantity of signal collection and output channel interfaces of the electrical channel adaptation layer 21 is adjusted relative to a total quantity of ECU interface types that may be used in the vehicle simulation apparatus 1, for example, a 20% redundancy design is performed, to meet an adaptation requirement when ECU interfaces or a quantity of interfaces changes.

According to the foregoing setting manner, the electrical interfaces of the ECUs of the vehicle simulation apparatus 1 are directly led into the test apparatus 2. The test apparatus 2 is further configured to implement information exchange between the vehicle controllers of the vehicle simulation apparatus, to decouple direct interaction functions between the ECUs. Function implementation of the ECUs may be processed by the test apparatus 2. The test apparatus 2 can freely and flexibly perform processing on the corresponding ECUs of the vehicle simulation apparatus 1, to implement and check functions of the ECUs in a normal or abnormal condition; and may also send data of one or more ECUs of one vehicle simulation apparatus 1 to another vehicle simulation apparatus 1. For example, in a scenario in which an ECU of one vehicle simulation apparatus 1 is powered off or a fault occurs in a simulated or real load of the vehicle simulation apparatus 1 and an ECU of a same type in another vehicle simulation apparatus needs to be temporarily used as a substitute to complete vehicle control, the central scheduling apparatus 3 may be used to transmit test data or a simulation signal of the ECU of the same type in the another vehicle simulation apparatus 1 to the vehicle simulation apparatus 1, to complete a test service. In this way, function complementation capabilities between the vehicle simulation apparatuses 1 can be greatly enhanced, and different vehicle simulation apparatus configurations are flexibly performed for different feature test requirements, to avoid a waste of instrument/device resources in the vehicle simulation apparatuses or the test apparatus during integration testing. For another example, when ECUs of different vehicle simulation apparatuses need to perform information exchange to cooperatively complete a function (for example, simulate information exchange between two vehicles to complete a coordination function, for example, a vehicle following function), information exchange between the ECUs of the different vehicle simulation apparatuses may be alternatively implemented by using the test apparatus 2.

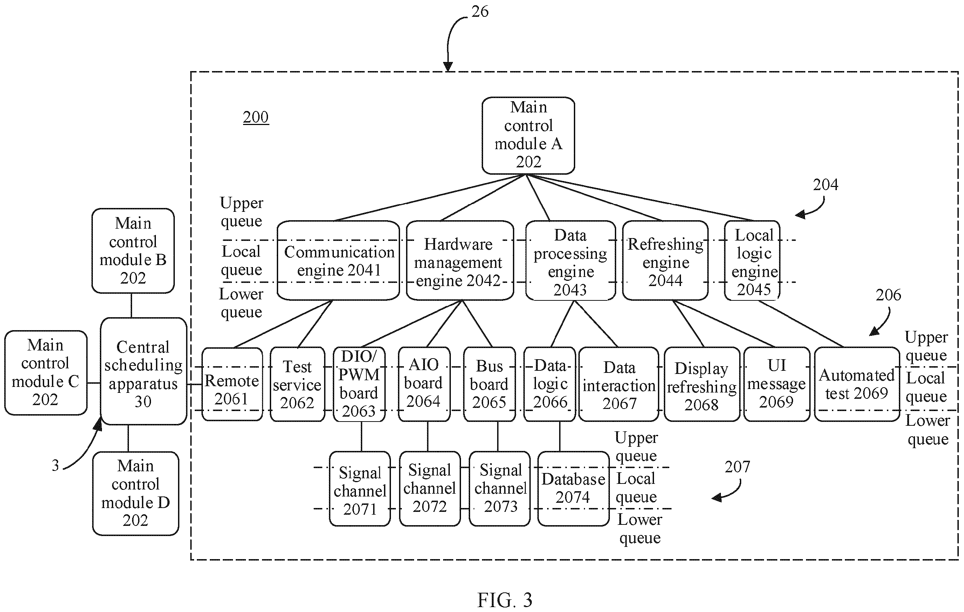

As shown in FIG. 3, the test apparatus 2 receives, by using the test software 26 of the test apparatus 2, scheduling instructions sent by the central scheduling apparatus 3 or scheduling instructions directly sent by the user on the user interface of the current test apparatus 2, and executes a test task based on a feature test case corresponding to the feature test requirement.

In this embodiment, Lab VIEW is used to implement the following logical architecture and data flow used when the test software 26 interacts with a corresponding vehicle simulation apparatus 1 and the central scheduling apparatus 3. A person skilled in the art may further use another programming language to implement a same concept.

Specifically, in this embodiment, the central scheduling apparatus 3 and each test apparatus 2 use a logical architecture including a five-layer thread and a three-layer queue in the thread.

As shown in FIG. 3, for the five-layer thread, the central scheduling apparatus 3 and the test apparatus 2 are constructed based on a producer-consumer model of Lab VIEW. The central scheduling apparatus 3 is corresponding to a top-layer central module 30 in the producer-consumer architecture. The top-layer central module 30 may be represented by MainVI-Central, is used for communication between the central scheduling apparatus 3 and a plurality of distributed test apparatuses 2, and directly interacts with the user 4. In FIG. 3, a local-end test apparatus 2 corresponding to each vehicle simulation apparatus is distributed at a lower end of the top-layer central module 30. Test software 26 of each local-end test apparatus 2 uses a multi-layer thread, is constructed by multi-layer functional modules 200, and uses a manner of dynamically invoking concurrent threads. The threads from an upper layer to a lower layer are respectively corresponding to a main control module 202, a plurality of engine (Engine) modules 204, at least one functional submodule 206, at least one operation submodule 207, a lower-layer submodule, and the like. The functional submodule 206 is located on a first-layer logic function subthread (which may be referred to as SubThread-L1) classified based on a function type, and the operation submodule 207 is located at a lower layer of the first-layer logic function subthread and is located on a second-layer logic function subthread (which may be referred to as SubThread-L2) classified based on a specific operation. The main control module 202 is a top-layer functional module of the test software 26, and is scheduled by the top-layer central module 30, namely, MainVI-Central, of the central scheduling apparatus 3. Each main control module 202 is configured to control corresponding downstream functional modules at each layer. In this embodiment, test software 26 of four local-end test apparatuses 2 under the MainVI-Central module is shown, and top-layer functional modules may be named Main VI-A, MainVI-B, MainVI-C, and MainVI-D respectively, serving as main control modules 202. The central scheduling apparatus 3 becomes an upper-layer management and forwarding node of the plurality of distributed test apparatuses 2 by using the top-layer central module 30, to provide a path for data and logic exchange between the vehicle simulation apparatuses 1 coupled to the test apparatuses 2, and provide a possibility for function complementation between the test apparatuses 2.

A program architecture of the test software 26 in which the main control module 202, namely, MainVI-A, is located is used as an example for description, and reference is made to a dashed-line box in FIG. 3. For example, the test software 26 in which the main control module 202, namely, MainVI-A, is located uses a four-layer thread, that is, four-layer modules. A concurrent thread manner used by the multi-layer modules is as follows: The main control module 202, namely, MainVI-A, on a top-layer thread of the test software 26 schedules the plurality of engine modules 204 on subthreads of the main control module 202 in a concurrent thread manner; the functional submodules 206 respectively coupled to the engine modules 204 are scheduled in a concurrent thread manner by the engine modules 204 corresponding to the functional submodules 206; and the at least one operation submodule 207 respectively coupled to the functional submodules 206 is scheduled in a concurrent thread manner by the AIO functional submodules 206 corresponding to the operation submodule 207. In other words, an upper-layer functional module used as a parent thread is used to dynamically invoke a lower-layer functional module used as a subthread. The multi-layer module architecture can effectively disperse a thread bearing capacity and determine a data flow direction.

As a top-layer module of an independent single local-end test apparatus 2, the main control module 202, namely, MainVI-A, schedules downstream threads, and presents data to the user in response to the user instructions. In the foregoing integration testing scenario, when the upper-layer central scheduling apparatus 3 manages a plurality of local-end test apparatuses 2 together, the central module 30, namely, MainVI-Central, of the central scheduling apparatus 3 replaces the main control module 202 to interact with the user. To be specific, the user initiates a test service requirement by using the central scheduling apparatus 3, and the central scheduling apparatus 3 monitors the plurality of distributed local-end test apparatuses 2 and generates scheduling instructions based on the test service requirement. For example, the central scheduling apparatus 3 simultaneously sends test cases to the plurality of test apparatuses 2, and requires these test apparatuses 2 to execute a test task for the feature simultaneously. The test apparatus 2 or these test apparatuses 2 invoke downstream functional modules at each layer in parallel to complete the test task.

The engine modules 204 herein are a communication engine module 2041, a hardware management engine module 2042, a data processing engine module 2043, a display refreshing engine module 2044, and a local logic engine module 2045. These engine modules form an engine layer of the local-end test apparatus 2 in a parallel structure, and are respectively configured to schedule the functional submodules 206 at a lower layer of the engine modules and even operation submodules 207 at a lower layer of the functional submodules 206. In this way, when a fault occurs in a downstream functional submodule or an ECU connected to a downstream functional submodule, a corresponding engine thread may be used to close a data exchange channel of the downstream functional submodule (disable thread invocation), so that execution of other functional submodules or logic functions of ECUs is not affected.

The communication engine module 2041 is configured to externally communicate with the test apparatus 2 and receive a signal of scheduling instructions that enable the current test apparatus 2 to implement a test, where the scheduling instructions are generated based on the test service requirement of the user. In this embodiment, each test apparatus 2 communicates with other test apparatuses 2 through the upper-layer central scheduling apparatus 3. The communication engine module 2041 may communicate externally by using a general communication protocol, for example, an Internet transmission protocol TCP/IP. A functional submodule coupled to the communication engine module 2041 includes but is not limited to a remote data transmission functional submodule 2061, for example, referred to as RemoteDataTrans. The remote data transmission functional submodule 2061 is located on the first-layer logic function subthread (SubThread-L1) under the communication engine module 2041 and is responsible for implementing information exchange with the central scheduling apparatus, for example, by using the network transmission protocol TCP/IP and based on a remote command (RemoteCMD) of the top-layer central module 30, namely, MainVI-Central, for example, central scheduling (Central Scheduling) instructions, to implement data exchange between different vehicle simulation apparatuses 1. The remote data transmission functional submodule 2061 is an interface for data exchange between the vehicle simulation apparatus 1 corresponding to the current test apparatus 2 and an external vehicle simulation apparatus 1. According to the foregoing description, in this embodiment, because function implementation of the ECUs and data transmission between the ECUs of the vehicle simulation apparatus 1 are all processed by the corresponding test apparatus 2, the remote data transmission functional submodule 2061, namely, RemoteDataTrans, is connected to the top-layer central module 30, namely, MainVI-Central, for example, by using the TCP/IP, to implement data exchange between the current local-end test apparatus 2 and other local-end test apparatuses, including data exchange about the ECUs of the vehicle simulation apparatus 1.

In addition, functional submodules coupled to the communication engine module 2041 may further include a local test service functional submodule 2062, for example, referred to as LocalTestService. The local test service functional submodule 2062 is configured to collect a transmitted signal by using the network transmission protocol, to implement a test on the vehicle simulation apparatus. In this embodiment, a management function of hardware whose data type is suitable for communication, for example, by using the TCP/IP is encapsulated on lower-layer threads of the TCP/IP communication engine module 2041. The hardware that is suitable for performing communication by using the TCP/IP may be an instrument/device that performs communication by using a VISA, for example, an oscilloscope or a programmable power supply. The local test service functional submodule LocalTestService is configured to collect, based on the TCP/IP, signals of these instruments/devices that perform communication by using the VISA. In this way, the communication engine module 2041 can also be responsible for some local test services to share a part of work of the hardware management engine module 2042. Moreover, it is convenient for the test devices that perform communication by using the TCP/IP to use resources allocated for a thread of the TCP/IP communication engine module 2041 to perform a test operation, and therefore test efficiency is improved.

The hardware management engine module 2042 is responsible for managing most of the test devices 25, and implements information exchange between the test device and the vehicle simulation apparatus by scheduling the test device 25. The hardware management engine module 2042 may be referred to as hardware. The communication engine module 2041 generates the test scheduling instructions based on the test service requirement of the user. The hardware management engine module 2042 determines, based on the test scheduling instructions, a test device 25 related to a specific feature test, to generate scheduling instructions related to the test device 25, thereby scheduling the related test device. The hardware management engine module 2042 feeds back test data collected by the related test device 25 for the vehicle controller 15, for example, original data such as a signal status (digital parameter) of a hard wire pin of an ECU and an analog parameter of a pin, to the main control module 202 until the data is presented to the user; or may directly exchange original data with another engine module 204, for example, the following data processing engine module 2043, to further process the original data. In addition, the hardware management engine module 2042 is configured to monitor a channel of the managed test device 25, and is responsible for implementing adaptation between the channel of the test device 25 and a channel of the vehicle controller 15 by using the electrical channel adaptation layer 21. When an input/output error occurs on a board or a channel, the hardware management engine module 2042 may separately close the board or the channel.

Functional submodules 206 coupled to the hardware management engine module 2042 may be classified into a plurality of parallel functional submodules 206 based on types of signals and/or buses tested by the test device. In this embodiment, for example, the functional submodules 206 are classified into a hardware functional submodule for testing a digital parameter, a hardware functional submodule for testing an analog parameter, and/or a hardware functional submodule for testing a bus signal. For example, in FIG. 3, a board for testing a DIO/PWM digital signal is allocated to a functional submodule 2063, a board for testing an AIO analog signal is allocated to a AIO functional submodule 2064, and a board for testing a bus Modbus/CAN/LIN is allocated to a functional submodule 2065. In this embodiment, each functional submodule 206 coupled to the hardware management engine module 2042 uses a PXIeBoard series board, for example, a PXIeBoard 6528. It can be understood that each functional submodule in a downstream of the hardware management engine module 2042 may be directly configured according to a physical form of an actual board, that is, each board is corresponding to one functional submodule 206.

In addition, because the hardware management engine module 2042 manages many hardware boards, and each board is integrated with many functions. Therefore, to further disperse the thread bearing capacity and determine the data flow direction, the second-layer logic function subthread (SubThread-L2) may be further established under the first-layer logic function subthread (SubThread-L1) on which the functional submodules 206 in the downstream of the hardware management engine module 2042 are located, so as to bear at least one operation submodule 207. In this way, operation requests for the test devices or the boards are implemented separately based on signal channels in a concurrent thread manner. For example, in FIG. 3, the DIO/PWM functional submodule 2063, the AIO functional submodule 2064, and the Modbus/CAN/LIN functional submodule 2065 may respectively control corresponding signal channel (SignalChannel) operation submodules 2071, 2072, 2073, and the like on lower-layer threads of the respective functional submodules to implement actual control respectively on specific board drivers that are based on the digital parameter, the analog parameter, and the bus signal, such as read, write, and initialization. In terms of hardware, the electrical channel adaptation layer of the test apparatus 2 is connected to the second terminal block of the coupled vehicle simulation apparatus 1, so that interfaces of pins of the ECUs may be respectively connected to corresponding signal channels of the functional submodules 2063 to 2065 coupled to the hardware management engine module 2042, and then the signal channel operation submodules 2071 to 2073 complete operations, such as signal collection or output for the ECUs.

It can be understood that in this embodiment, only two-layer submodules are provided in the downstream of the hardware management engine module 2042: the functional submodules 206 and the operation submodules 207. A person skilled in the art may extend more layers of logic function subthreads to downstreams of the signal channel operation submodules 2071 to 2073 based on a thread bearing capability of the test apparatus 2, to control more layers of submodules.

The data processing engine module 2043 is referred to as DataProcess, and is responsible for managing a local database of the test apparatus 2, to implement processing of test data from the vehicle simulation apparatus 1, including but not limited to storage, analysis, conversion, filtering, and screening. Specifically, after collecting original data such as digital parameters of the ECUs that come from the vehicle simulation apparatus 1 and execution signals of the actuators, the hardware management engine module 2042 may directly send the original data to the data processing engine module 2043. In the data processing engine module 2043, the original data is directly stored in the local database. When the original data has low precision or lacks a visual attribute, the data processing engine module 2043 processes the original data. For example, when the original data is an analog parameter, processing such as filtering and noise reduction may need to be performed on the original data, and/or the original data may need to be further converted into a form of a sine wave or a cosine wave. Processed data may be sent to the local logic engine module 2045 described below for further logic function processing.

In this embodiment, functional submodules 206 coupled to the data processing engine module 2043 are configured to implement database logic, and may be classified into a data logic (DataLogic) functional submodule 2066 and an interface data interaction (DataInteractive) functional submodule 2067 based on data processing types. The data logic functional submodule 2066 may perform data processing on data from the vehicle simulation apparatus based on algorithm logic, judgment logic, and the like of the database. The interface data interaction functional submodule 2067 may implement an interaction interface function of a user interface (UI), a front panel (Front Panel), or the like that is of the test apparatus 2 and that is used for displaying test statuses or test results of pins of tested ECUs.

In addition, in consideration of the thread bearing capability, in this embodiment, a database management (Database) operation submodule 2074 is further obtained through extension at a lower layer of the data logic (DataLogic) functional submodule 2066, and performs operations in the database, such as data storage, playback, and analysis. A person skilled in the art may extend more layers of threads to a downstream of the database management operation submodule 2074 based on the thread bearing capability of the local-end test apparatus 2, to control more layers of submodules.

The display refreshing engine module 2044 is configured to refresh and display a data display area on a host computer interface, and may be referred to as MainFP. The data display area may be displayed by using a window or a control of the front panel (Front Panel, FP), and is used to display the test results or the test statuses of the pins of the tested ECUs, and/or an alarm a prompt, and the like. Display manners include but are not limited to forms of signal light display, variable value display, and waveform display.

In this embodiment, functional submodules 206 at a lower layer of the display refreshing engine module 2044 may include a display refreshing functional submodule 2068, configured to directly present test signals and test statuses of the vehicle simulation apparatus, especially test signals and test statuses of the pins of the tested ECUs and the electrical loads. Optionally, the functional submodules 206 coupled to the display refreshing engine module 2044 further include a user interface message (UI Msg) functional submodule 2069, configured to determine the test signals and the test statuses, and generate result messages in a form of a warning, a prompt, a test report, and/or the like based on determining conclusions.

It can be understood that, if the test apparatus 2 serves as a background relative to the upper-layer central scheduling apparatus 3 to execute a test task, the test apparatus 2 does not need to be oriented to the user, so that a user interface (UI) and a refresh service may be omitted. In this case, the display refreshing engine module 2044 and the submodules in the downstream of the display refreshing engine module 2044 are not needed.

The local logic engine module 2045 is configured to use the hardware management engine module 2042 to automatically execute local logic corresponding to the test service requirement, and may be referred to as LocalFunction. The local logic includes logical operation, judgment, and sequence control processes that are performed in the test apparatus 2 and that include but are not limited to an automated test (Auto Test) and troubleshooting (Debug). The local logic is relative to remote logic used in interaction between the current test apparatus 2 and other test apparatuses 2. An implementation of this embodiment includes but is not limited to the following: The local logic engine module 2045 stores specific test cases for test requirements of various features, where the test cases are used to perform testing and fault diagnosis on logic functions of the ECUs and a logic exchange process between an ECU and a peripheral. For example, logic exchange between a VCU and a thermal management system (Thermal Management System, TMS) is tested based on a test case for controlling the TMS. The local logic is executed as follows: When it is found that the VCU receives a PIO (Pulse Input/Output) signal, that is, in the local-end test apparatus 2, when it is found that a pin of the VCU outputs a high-level status signal, the local logic engine module 2045 may require the VCU to control running of the TMS, for example, but not limited to, the local logic engine module 2045 may control power-on/off of the TMS. For another example, when a control status of the ECU on an external circuit needs to be tested, for example, when the ECU needs to control a temperature sensor used for the TMS, the local logic engine module 2045 simulates an analog parameter or a programmable resistance based on a corresponding test case by using a corresponding board of the hardware management engine module 2042, to simulate the temperature sensor, and monitors whether a control signal of the ECU complies with a preset normal result in the test case. For still another example, if the ECU needs to set a target temperature for the enabled TMS, the local logic engine module 2045 may also implement related logic exchange and monitoring based on a test case.

In this embodiment, functional submodules 206 at a lower layer of the local logic engine module 2045 may include but is not limited to an automated test functional submodule 2060, which stores automated test scripts of logic functions, for example, various test cases including specific implementation steps. In this way, the automated test functional submodule 2060 may implement, based on the specific implementation steps of the test cases, service logic or feature logic of various specific test functions corresponding to the test service requirement. For example, a test procedure in a test case in which an air conditioner startup function is enabled by using a voice includes: inputting voice instructions, feeding back an execution result by an air conditioner, and indicating that a test succeeds by using a feedback result "success", or indicating that a test fails by using a feedback result "failure".

The communication engine module 2041, the hardware management engine module 2042, the data processing engine module 2043, the display refreshing engine module 2044, and the local logic engine module 2045 may directly perform logic exchange or data exchange with each other, or may perform interaction with each other through the main control module 202 on a common parent thread thereof.

By using the foregoing multi-layer functional modules, the test software 26 may monitor a board channel of the test device 25, and implement at least one of the following tests: performing monitoring or data collection on the ECU, performing monitoring or data collection on the electrical load 17, providing a simulated interface electrical signal of the electrical load 17, performing actuator control, performing vehicle logic power-on/off, performing fault injection, processing collected data, and performing other functions. For a same test project, test software of each test apparatus 2 may be replicated, and there is no difference between the test apparatuses 2. Each test apparatus 2 is connected to the central scheduling apparatus 3 by using a general network transmission protocol, for example, the TCP/IP, to perform data and logic function exchange between the vehicle simulation apparatuses 1.

As shown in FIG. 3, for the three-layer queue, each engine module 204 and each functional submodule 206 include an upper queue (Upper Queue) module, a local queue (Local Queue) module, and a lower queue (Lower Queue) module that are configured to implement information exchange. The upper queue module of the engine module 204 is configured to implement information exchange with the main control module 202. The local queue module of the engine module 204 is configured to implement information exchange in the current engine module. The lower queue module of the engine module 204 is configured to implement information exchange with an upper queue module of a coupled functional submodule. Each of the operation submodules 207 includes an upper queue module, a local queue module, and a lower queue module that are configured to implement information exchange. The local queue module of the functional submodule 206 is configured to implement information exchange in the current functional submodule. The lower queue module of the functional submodule 206 is configured to implement information exchange with an upper queue module of a coupled operation submodule 207. A function of the local queue of each functional module is to perform data processing in the current functional module or transmit data between the upper queue module and the lower queue module in the current functional module.

It can be learned that in the software logical architecture of the multi-layer functional modules 200, except that the main control module 202 includes a two-layer queue: a similar local queue (Local Queue) module and a similar lower queue (Lower Queue) module, each lower-layer functional module managed by the main control module 202, that is, each engine module 204 and each submodule 206 and/or each submodule 207 in a downstream of the engine module 204, is formed by a three-layer queue: an upper queue (Upper Queue) module responsible for information exchange with a module on a parent thread, a local queue (Local Queue) module responsible for information exchange in the current functional module, and a lower queue (Lower Queue) module responsible for information exchange with a module on a subthread.

To be specific, for each functional module in a downstream of the main control module 202, an upper queue module of the current functional module is located in a same queue as a lower queue module of a functional module on a parent thread of the current functional module, and can exchange information only with the functional module on the parent thread of the current functional module on a data flow channel; a local queue module of the current functional module is used for information exchange in the current functional module; and a lower queue module of the current functional module is located in a same queue as an upper queue module of a functional module on a subthread of the current functional module, and is used for information exchange with the functional module on the subthread of the current functional module.

In this embodiment, based on the three-layer queue architecture, synchronization control can be implemented for a small quantity of types or a small quantity of information exchange requirements. In an integration testing scenario for a plurality of projects and a plurality of vehicle models, in case of diversified data types and a large quantity of information exchange requirements, the three-layer queue in this embodiment can still determine a data flow direction. When a channel status bit is requested, an instruction is delivered instead of a variable, and only a status of the variable is returned instead of the variable. In this way, control instructions transmitted from an upper layer to a lower layer are separated from data fed back from a lower layer to an upper layer, to cooperate with highly concurrent free scheduling of the multi-layer functional modules.

The following uses an example to describe a procedure in which the multi-layer functional modules of the test apparatus 2 in this embodiment are combined with the three-layer queue.

A queue name of an upper queue of each current functional module is a module name of a functional module on a parent thread. The current functional module can send data to only the functional module on the parent thread. Functional modules at the lower layer of the engine layer cannot directly exchange information, to avoid logic function disorder caused by random data forwarding. A local queue is used to receive/send information about a functional module on a parent thread or a subthread, and a lower queue is used to deliver instructions and data to a functional module on a subthread. In other words, except for the main control module 202, each functional module is corresponding to only one functional module on a parent thread, but may be corresponding to a plurality of submodules. In addition, the engine modules 204 are coupled to a same module on a same parent thread, namely, the main control module 202, and are jointly controlled and managed by the main control module 202. The main control module 202 may be responsible for only instruction exchange or a small amount of data exchange, and a large amount of data may be directly exchanged between the engine modules 204.

The logical architecture algorithm in which the multi-layer modules are combined with the three-layer queue in the modules enables the functional modules to use the manner of dynamically invoking concurrent threads, to implement free scheduling for the modules on the threads.

The following uses an example of a test requirement to describe a procedure for one test apparatus 2.
1. If a user needs to obtain a signal status (digital parameter) of a hard wire pin of an ECU, the user delivers a request by using a control on an interface of the main control module 202 (MainVI), and a lower queue (Lower queue) module of the MainVI sends a request flag.
2. An upper queue (Upper queue) module in the hardware management engine module 2042 (Hardware) at the engine layer receives the request flag sent by the lower queue of the MainVI, and then sends the request flag to a local queue (Local queue) module in the hardware module. The local queue module converts the request flag into control instructions for a board channel according to the user's intention, and sends the control instructions through a lower queue (Lower queue) module of the hardware.
3. After receiving the control instructions, an upper queue module of the DIO/PWM functional submodule 2063 sends the control instructions related to a board operation, for example, reading the board channel, to a local queue of the DIO/PWM functional submodule 2063. The local queue converts the received control instructions into an actual operation request for a board driver, and sends the operation request through a lower queue.
4. After receiving the operation request, an upper queue of the signal channel operation submodule 2071 at the lower layer of the DIO/PWM functional submodule 2063 reads, for example, statuses associated with DIO channels and ECU pins, and uploads status data through the upper queue after the reading is completed. It can be understood that, if there is no further extension requirement, a lower queue module of the signal channel operation submodule 2071 that is at a bottommost layer is not used, and a local queue module of the signal channel operation submodule 2071 is only used for performing processing and transmission on local data.
5. Data obtained by the signal channel operation submodule 2071 is reversely transmitted layer by layer until the data reaches the MainVI, or the display refreshing engine module 2044 presents the data to the user. In addition, the MainVI also sends a feedback status to the data processing engine module 2043 based on a service requirement to perform possible data processing, such as storage and downstream forwarding, and optionally further sends the feedback status to the local logic engine module 2045.

In this embodiment, functional modules can be independently executed and logically independent of each other during execution. Each module can run with highest efficiency specified for the module. If running of any module crashes or breaks down, execution of other modules is not affected, and the other modules can still perform their own functions. Especially in a scenario with many data types and a large data volume in an instrument board, each board function are independently performed, to improve overall program stability and reliability.

Based on this, after the board functions and service logic may be implemented in the manner of dynamically invoking concurrent threads, in a scenario in which there are diversified data types and a large amount of information to be exchanged and data needs to be transmitted and processed between a plurality of threads, a one-layer queue cannot meet requirements. Therefore, in this solution, a one-layer queue is extended into a three-layer queue, to determine a data flow direction, encapsulate logic functions, avoid contention caused when threads perform operations on a variable, and implement information exchange between a parent thread and a subthread.

A procedure for an optimized three-layer queue data flow is highly compatible with the architecture including high-parallel threads.

The foregoing procedure is mainly an example of the test apparatus 2 during running. Further, in this embodiment, the user may set a priority of each module based on a priority of a test service requirement and a priority of corresponding function logic. A priority setting manner is, for example, but is not limited to the following.

At the engine layer, a real-time priority is set for the communication engine module 2041, a high priority is set for the hardware management engine module 2042, a standard priority is set for the data processing engine module 2043, a background priority is set for the display refreshing engine module 2044, and a subroutine priority is set for the local logic engine module 2045.

At the layer of the functional submodules 206, a real-time (highest) priority is set for the remote data transmission functional submodule 2061, a second highest priority is set for the local test service functional submodule 2062, standard priorities are set for the DIO/PWM submodule 2063 and the AIO functional submodule 2064, a high priority is set for the Modbus/CAN/LIN submodule 2065, a standard priority is set for the data logic (DataLogic) functional submodule 2066, a standard priority is set for the data interaction functional submodule 2067 interacting with the interface or the front panel, a background priority is set for the front panel refresh (FP Refresh) submodule 2068, a background priority is set for the user interface message (UI Msg) submodule 2069, and a subroutine priority is set for the automated test functional submodule 2060.

At the layer of the operation submodules 207, subroutine priorities are set for the operation submodules 207.

In case of dynamically invoking highly concurrent threads in this embodiment, setting a subroutine priority is performed according to a specified priority policy. The hardware management engine module 2042 is responsible for, for example, inputting/outputting a high-speed digital signal, collecting high-frequency waveform data, and processing a large amount of data during collection of data of a plurality of channels. A scheduling priority of the hardware management engine module 2042 should be obviously higher than scheduling priorities of the data processing engine module 2043, the display refreshing engine module 2044, and the local logic engine module 2045, to meet a delay requirement of a module that needs to run at a high speed. The remote data transmission functional submodule 2061 coupled to the communication engine module and the communication engine module that perform information exchange by using the TCP/IP undertake a data exchange task between a plurality of vehicle simulation apparatuses 1. When the highest priority is set for the communication engine module, a disadvantage of system performance deterioration caused by a network delay when the plurality of vehicle simulation apparatuses 1 are in different regions can be eliminated. Therefore, scheduling priorities of some modules, especially the bus functional modules, can be improved based on service requirements to improve execution efficiency of an important function.

Certainly, based on an actual situation, if the plurality of vehicle simulation apparatuses 1 are all located in a same region and there is no network delay problem, the priority of the communication engine module 2041 may be alternatively lowered. A priority setting solution is flexible for a person skilled in the art.

In this embodiment, a priority-based scheduling control policy is used to control the scheduling priorities of the modules, to meet requirements for decoupling functions between ECUs in each vehicle simulation apparatus 1 in the integration testing scenario, forwarding ECU data between environments, and interaction between the vehicle simulation apparatuses 1. In this way, when any ECU is powered off or a function of any ECU is abnormal, feature tests can still be normally performed on ECUs in other environments.

Generally, a wait function is used for priority control, and the wait function is used to slow down an execution speed of a thread with a lower priority. In this way, a CPU has more time to process data of a thread with a higher priority. A problem of this method is that when a system scale is large, priorities of different threads cannot be accurately determined. Consequently, in some occasional cases, data of a thread cannot be processed in time, and even the thread is incorrectly disabled or suspended.

In some embodiments, a timeout control algorithm is proposed to control sorting of threads with a same priority. After timeout times reach a preset quantity of times, for example, after data processing that a module attempts to perform times out for three times, a priority of the module is automatically increased by one level.

In scenarios in which high data synchronization is needed, global variables can be used. Due to a multi-thread architecture, when different threads perform operations on a same variable, the variable is in a "contention state". The three-layer queue mode used in this application avoids contention caused when threads perform the operations on the variable. However, to prevent a case in which a value of the variable is disordered when the variable is read and written because a queue overflow and crash are easily generated when a queue processes a high-speed data flow, a synchronization algorithm for a functional global variable is used to implement an operation on the variable. This meets a requirement of the test system for real-time quality of data when a large amount of data is exchanged.

A person of ordinary skill in the art can be aware that, in combination with the examples described in embodiments disclosed in this specification, units and process steps can be implemented by electronic hardware or a combination of computer software and electronic hardware. Whether the functions are performed by hardware or software depends on particular applications and design constraints of technical solutions. A person skilled in the art may use a different method to implement the described functions for each particular application, but it should not be considered that the implementation goes beyond the scope of this application.

It can be clearly understood by a person skilled in the art that, for the purpose of convenient and brief description, for the test method described above, refer to corresponding processes in the foregoing embodiments of the test apparatus 2 and the test system 100. Details are not described herein again.

In the several embodiments provided in this application, it should be understood that the disclosed system, apparatuses, and method may be implemented in other manners. For example, the described apparatus embodiments are merely examples. For example, module division is merely logical function division and may be other division during actual implementation. For example, a plurality of modules may be combined or may be integrated into another system, or some features may be ignored or not be performed. In addition, the displayed or discussed mutual couplings or direct couplings or communication connections may be implemented through some interfaces. The indirect couplings or communication connections between the apparatuses or units may be implemented in electrical, mechanical, or another form.

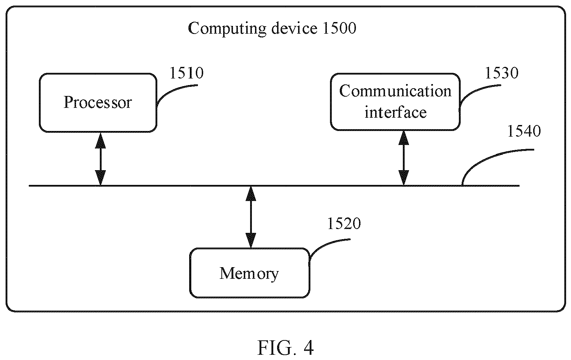

FIG. 4 is a schematic diagram of a structure of a computing device 1500 according to an embodiment of this application. The computing device 1500 includes a processor 1510, a memory 1520, a communication interface 1530, and a bus 1540.

It should be understood that the communication interface 1530 in the computing device 1500 shown in FIG. 4 may be configured to communicate with another device.

The processor 1510 may be connected to the memory 1520. The memory 1520 may be configured to store program code and data. Therefore, the memory 1520 may be a storage unit in the processor 1510, an external storage unit independent of the processor 1510, or a component including the storage unit in the processor 1510 and the external storage unit independent of the processor 1510.

Optionally, the computing device 1500 may further include a bus 1540. Both the memory 1520 and the communication interface 1530 may be connected to the processor 1510 through the bus 1540. The bus 1540 may be a peripheral component interconnect (Peripheral Component Interconnect, PCI) bus, an extended industry standard architecture (Extended Industry Standard Architecture, EISA) bus, or the like. The bus 1540 may be classified into an address bus, a data bus, a control bus, and the like. For ease of representation, the bus is represented by using only one line in FIG. 4, which, however, does not mean that there is only one bus or one type of bus.

It should be understood that, in this embodiment of this application, the processor 1510 may use a central processing unit (central processing unit, CPU). The processor may be alternatively another general purpose processor, a digital signal processor (digital signal processor, DSP), an application-specific integrated circuit (application-specific integrated circuit, ASIC), a field programmable gate array (field programmable gate array, FPGA), another programmable logic device, a discrete gate, a transistor logic device, a discrete hardware component, or the like. The general purpose processor may be a microprocessor, or the processor may be any conventional processor or the like. Alternatively, the processor 1510 uses one or more integrated circuits to execute a related program, to implement the technical solutions provided in embodiments of this application.

The memory 1520 may include a read-only memory and a random access memory, and provide instructions and data for the processor 1510. A part of the processor 1520 may further include a non-volatile random access memory. For example, the processor 1520 may further store device type information.

When the computing device 1500 runs, the processor 1510 executes computer executable instructions in the memory 1520 to perform operation steps of the foregoing method.

When the functions are implemented in a form of a software functional module and sold or used as an independent product, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for instructing a computer device (which may be a personal computer, a server, a network device, or the like) to perform all or some of the steps of the methods described in embodiments of this application. The foregoing storage medium includes: any medium that can store program code, such as a USB flash drive, a removable hard disk, a read-only memory (Read-Only Memory, ROM), a random access memory (Random Access Memory, RAM), a magnetic disk, or an optical disc.

An embodiment of this application further provides a computer-readable storage medium. The computer-readable storage medium stores a computer program, and when the program is executed by a processor, the program is used to perform a test method. The method includes at least one of the solutions described in the foregoing embodiments.

The computer storage medium according to this embodiment of this application may be one computer-readable medium or any combination of a plurality of computer-readable media. The computer-readable medium may be a computer-readable signal medium or a computer-readable storage medium. The computer-readable storage medium may be, for example, but not limited to, an electrical, magnetic, optical, electromagnetic, infrared, or semiconductor system, apparatus, or device, or any combination thereof. More specific examples (a non-exhaustive list) of the computer-readable storage medium include an electrical connection having one or more conducting wires, a portable computer disk, a hard disk, a random access memory (RAM), a read-only memory (ROM), an erasable programmable read-only memory (EPROM or flash memory), an optical fiber, a portable compact disc read-only memory (CD-ROM), an optical storage device, a magnetic storage device, or any suitable combination thereof. In this document, the computer-readable storage medium may be any tangible medium including or storing a program that may be used by an instruction execution system, apparatus, or device, or used in combination with an instruction execution system, apparatus, or device.

The computer-readable signal medium may include a data signal propagated in a baseband or propagated as a part of a carrier, where the computer-readable signal medium carries computer-readable program code. Such a propagated data signal may take a variety of forms, including but not limited to an electromagnetic signal, an optical signal, or any suitable combination thereof. The computer-readable signal medium may be alternatively any computer-readable medium other than the computer-readable storage medium. The computer-readable medium may send, propagate, or transmit the program used by the instruction execution system, apparatus, or device, or used in combination with the instruction execution system, apparatus, or device.

The program code included in the computer-readable medium may be transmitted by using any suitable medium, including but not limited to wireless, an electric wire, an optical cable, an RF, or any suitable combination thereof.

Computer program code used to perform operations in this application may be written in one or more program design languages or a combination thereof. The program design languages include object-oriented program design languages such as Java, Smalltalk, and C++, and further include a conventional procedural program design language such as a C language or a similar program design language. The program code may be executed entirely on a user computer, may be partially executed on a user computer, may be executed as an independent software package, may be partially executed on a user computer and partially executed on a remote computer, or may be entirely executed on a remote computer or a server. When a remote computer is involved, the remote computer may be connected to a user computer by using any type of network, including a local area network (LAN) or a wide area network (WAN), or may be connected to an external computer (for example, connected by using an Internet service provider through the Internet).

It should be noted that the foregoing descriptions are merely examples of embodiments and technical principles of this application. A person skilled in the art understands that the present invention is not limited to specific embodiments described herein, and a person skilled in the art can make various obvious changes, readjustments, and replacements without departing from the protection scope of the present invention. Therefore, although this application is described in detail by using the foregoing embodiments, the present invention is not limited to the foregoing embodiments. More other equivalent embodiments may be further included without departing from the concept of the present invention, and all fall within the protection scope of the present invention.

## Claims

1. A test system, comprising: a central scheduling apparatus, a test apparatus, and a vehicle simulation apparatus, wherein the test apparatus establishes communication with the central scheduling apparatus;
the central scheduling apparatus is configured to send a test service requirement to the test apparatus;
the test apparatus is configured to test the vehicle simulation apparatus based on the test service requirement; and
the vehicle simulation apparatus comprises a vehicle controller and a second terminal block, the vehicle controller and the test apparatus are connected to the second terminal block to establish communication, and the vehicle controller is configured to respond to the test performed by the test apparatus.

2. The test system according to claim 1, wherein the vehicle simulation apparatus further comprises an electrical load and a first terminal block, and the vehicle controller and the electrical load are connected to the first terminal block to establish communication.

3. The test system according to claim 2, wherein the first terminal block is further connected to the second terminal block.

4. The test system according to any one of claims 1 to 3, wherein an interface that is of the second terminal block and that is configured to establish communication comprises a digital channel interface, an analog channel interface, and/or a bus channel interface.

5. The test system according to any one of claims 1 to 4, wherein the vehicle simulation apparatus comprises at least two vehicle controllers, and the test apparatus is further configured to implement communication between the at least two vehicle controllers.

6. The test system according to any one of claims 1 to 5, wherein there are at least two test apparatuses, there are at least two vehicle simulation apparatuses, and the at least two vehicle simulation apparatuses establish communication with the at least two test apparatuses in a one-to-one correspondence manner; and
the central scheduling apparatus is further configured to implement communication between the at least two test apparatuses.

7. A vehicle simulation apparatus, comprising a vehicle controller and a second terminal block, wherein
the vehicle controller and a test apparatus are connected to the second terminal block to establish communication.

8. The vehicle simulation apparatus according to claim 7, further comprising an electrical load and a first terminal block, wherein the vehicle controller and the electrical load are connected to the first terminal block to establish communication.

9. The vehicle simulation apparatus according to claim 8, wherein the first terminal block is further connected to the second terminal block.

10. Atest apparatus, comprising a communication engine module, a local logic engine module, a hardware management engine module, and a data processing engine module, wherein
the communication engine module is configured to receive a test service requirement of a central scheduling apparatus;
the local logic engine module is configured to implement a test case that fulfills the test service requirement, wherein the test case is used to describe service logic for testing a vehicle simulation apparatus;
the hardware management engine module is configured to manage running of a test device in the test apparatus in a process of implementing the test case, wherein the test device is configured to provide test signals for the vehicle simulation apparatus or collect data of the vehicle simulation apparatus; and
the data processing engine module is configured to process the data collected by the test device.

11. The test apparatus according to claim 10, further comprising a main control module, configured to control running of the communication engine module, the local logic engine module, the hardware management engine module, and the data processing engine module.

12. The test apparatus according to claim 10 or 11, further comprising:
a local test service functional submodule controlled by the communication engine module, wherein the local test service functional submodule is configured to collect the data of the vehicle simulation apparatus through signal transmission by using a network transmission protocol.

13. The test apparatus according to claim 10 or 11, further comprising:
a hardware functional submodule for testing a digital parameter, a hardware functional submodule for testing an analog parameter, and/or a hardware functional submodule for testing a bus signal, wherein these hardware functional submodules are controlled by the hardware management engine module.

14. The test apparatus according to claim 10 or 11, further comprising:
a signal channel operation submodule controlled by the hardware functional submodule, wherein the signal channel operation submodule is configured to control the test device to provide test signals or collect data on a digital channel, an analog channel, and/or a bus channel based on a signal type.

15. The test apparatus according to any one of claims 10 to 14, wherein each engine module, each functional submodule, and each operation submodule comprise an upper queue, a local queue, and a lower queue;
the upper queue is configured to implement information exchange with an upper-layer module;
the local queue is configured to implement information exchange between an upper queue and a lower queue in a current module;
the lower queue is configured to implement information exchange with a lower-layer module;
an upper-layer module of the engine module is the main control module, and a lower-layer module of the engine module is a submodule controlled by the engine module;
an upper-layer module of the functional submodule is an engine module that controls the functional submodule, and a lower-layer module of the functional submodule is an operation submodule controlled by the functional submodule; and
an upper-layer module of the operation submodule is a functional submodule that controls the operation submodule, and a lower-layer module of the operation submodule is a submodule that is controlled by the operation submodule and that is used for extension.

16. A test method applied to the test system according to any one of claims 1 to 6, wherein a vehicle controller of a vehicle simulation apparatus and a test apparatus are connected to a second terminal block of the vehicle simulation apparatus to establish communication between the vehicle controller and the test apparatus, and the test method comprises the following steps:
sending, by a central scheduling apparatus, a test service requirement to the test apparatus;
testing, by the test apparatus, the vehicle simulation apparatus based on the test service requirement; and
responding to, by the vehicle controller of the vehicle simulation apparatus, the test performed by the test apparatus.

17. The test method according to claim 16, wherein the vehicle simulation apparatus further comprises an electrical load and a first terminal block, and the test method further comprises:
establishing communication between the vehicle controller and the electrical load by connecting the vehicle controller and the electrical load to the first terminal block.

18. The test method according to claim 16 or 17, wherein the vehicle simulation apparatus comprises at least two vehicle controllers, and the test method further comprises:
performing communication between the at least two vehicle controllers by using the test apparatus.

19. The test method according to any one of claims 16 to 18, wherein there are at least two test apparatuses, there are at least two vehicle simulation apparatuses, the at least two vehicle simulation apparatuses establish communication with the at least two test apparatuses in a one-to-one correspondence manner, and the test method further comprises:
performing, by the central scheduling apparatus, communication between the at least two test apparatuses.

20. The test method according to claim 17, wherein the test performed by the test apparatus comprises at least one of the following:
performing monitoring or data collection on the vehicle controller;
performing monitoring or data collection on the electrical load;
providing a simulated interface electrical signal of the electrical load;
performing fault injection on the vehicle controller; or
processing collected data.

21. A test method applied to the test apparatus according to any one of claims 10 to 15, comprising the following steps:
receiving, by a communication engine module, a test service requirement of a central scheduling apparatus;
implementing, by a local logic engine module, a test case that fulfills the test service requirement, wherein the test case is used to describe service logic for testing a vehicle simulation apparatus;
managing, by a hardware management engine module, running of a test device in the test apparatus in a process of implementing the test case, wherein the test device is configured to provide test signals for the vehicle simulation apparatus or collect data of the vehicle simulation apparatus; and
processing, by a data processing engine module, the data collected by the test device.

22. The test method according to claim 21, further comprising: controlling, by a main control module, running of the communication engine module, the hardware management engine module, the data processing engine module, and the local logic engine module.

23. The test method according to claim 21 or 22, wherein each engine module, each functional submodule, and each operation submodule comprise an upper queue, a local queue, and a lower queue;
the upper queue performs information exchange with an upper-layer module;
the local queue performs information exchange between an upper queue and a lower queue in a current module;
the lower queue performs information exchange with a lower-layer module;
an upper-layer module of the engine module is the main control module, and a lower-layer module of the engine module is a submodule controlled by the engine module;
an upper-layer module of the functional submodule is an engine module that controls the functional submodule, and a lower-layer module of the functional submodule is an operation submodule controlled by the functional submodule; and
an upper-layer module of the operation submodule is a functional submodule that controls the operation submodule, and a lower-layer module of the operation submodule is a submodule that is controlled by the operation submodule and that is used for extension.

24. A computing device, comprising:
a bus;
a communication interface, wherein the communication interface is connected to the bus;
at least one processor, wherein the at least one processor is connected to the bus; and
at least one memory, wherein the at least one memory is connected to the bus and stores program instructions, and when the program instructions are executed by the at least one processor, the at least one processor is enabled to perform the method according to any one of claims 16 to 20 or perform the method according to any one of claims 21 to 23.

25. A computer-readable storage medium, wherein the computer-readable storage medium stores program instructions, and when the program instructions are executed by a computer, the computer is enabled to perform the method according to any one of claims 16 to 20 or perform the method according to any one of claims 21 to 23.
